# EUROPÄISCHE PATENTSCHRIFT

(11) **EP 2 839 723 B1**
(45) Veröffentlichungstag und Bekanntmachung des Hinweises auf die Patenterteilung: **27.04.2016**
(21) Anmeldenummer: 13717704.4
(22) Anmeldetag: 14.03.2013
(51) Int. Cl.: H05K 5/00, H05K 7/14

(54) **GEHÄUSE ZUR AUFNAHME EINER ELEKTRISCHEN LEITERKARTE**
HOUSING FOR RECEIVING AN ELECTRICAL CIRCUIT BOARD
BOÎTIER POUR LOGER UNE CARTE DE CIRCUIT IMPRIMÉ ÉLECTRIQUE

(30) Priorität: 18.04.2012 DE 102012103359
(43) Veröffentlichungstag der Anmeldung: 25.02.2015
(73) Patentinhaber: HARTING Electronics GmbH, 32339 Espelkamp (DE)
(72) Erfinder: LINDKAMP, Marc, 32312 Lübbecke (DE); BUSSMANN, Rainer, 49152 Bad Essen (DE)
(86) Internationale Anmeldenummer: PCT/DE2013/100099
(87) Internationale Veröffentlichungsnummer: WO 2013/156022

(56) Entgegenhaltungen:
- DE-T2- 69 427 128

## Beschreibung

Die Erfindung betrifft ein Gehäuse, sowie elektrische Leiterkarte zur Aufnahme in einem Gehäuse, entsprechend dem Oberbegriff der unabhängigen Anspruchs 1.

Derartige aus Formteilen zusammengesetzte Gehäuse zur Aufnahme elektrischer Leiterkarten sind in unterschiedlichsten Formen und Größen aus dem Stand der Technik bekannt. Die die Gehäuseteile bildenden Formteile bestehen zumeist aus Kunststoff. Die Gehäuse nehmen Leiterkarten für die unterschiedlichsten Funktionen, beispielsweise für Datenkommunikationsgeräte auf. Die Leiterkarten weisen regelmäßig Schnittstellen, Stromversorgungsanschlüsse sowie Bedienelemente auf, die über mindestens eine Kontaktierungsöffnung im Gehäuse zugänglich sind. Oft sind hierzu am Gehäuse Anschlussflansche und/oder Verrastungselemente für die in den Schnittstellen oder Anschlüssen aufzunehmenden Bauteile vorhanden.

Aus der DE 10 2005 002 138 A1 ist beispielsweise ein Gehäuse zur Aufnahme von elektrischen Leiterkarten bekannt, welches über Führungselemente sowie verschieb- und arretierbare Halteelemente verfügt. Die Halteelemente sind an den seitlichen Kanten der Leiterkarte anbringbar und fixieren diese. Durch Verschieben der Halteelemente ist die Position der Leiterkarte variierbar.

Aus der DE 694 27 128 T2 ist eine IC-Karte bekannt, bestehend aus einem zweiteiligen Gehäuse mit einer darin aufgenommenen Leiterkarte. In den Gehäusehälften sind mehrere, stufenförmig angeordnete Lagerpunkte vorgesehen, welche jeweils ein Niveau für die aufzunehmende Leiterkarte bilden. Je nachdem wie Ausnehmungen auf der aufzunehmenden Leiterkarte ausgebildet sind, liegt die Leiterkarte auf anderen Lagerpunkten, und somit Niveaus in den Gehäusehälften auf.

Aus der US 6,249,442 B1 ist eine Aufnahme für Leiterkarten bekannt, welche mehrere Leiterkarten in verschiedenen Niveaus aufnehmen kann. Die unterschiedlichen Niveaus werden dabei durch Abstandshülsen realisiert, welche zwischen die Leiterkarten eingesetzt werden. Die erste Leiterkarte liegt auf Lagerpunkten eines Gehäuses auf. Auf dieser Leiterkarte wird eine Abstandshülse positioniert und auf diese wiederum eine weitere Leiterkarte gesetzt. Mittels eines zweiten Gehäuses werden die beiden Leiterkarten, sowie die dazwischenliegende Abstandshülse und eine weitere, einen Ausgleich bildende Abstandshülse gehalten und fixiert. Um verschiedene Niveaus der Leiterkarten zu realisieren, müssen Abstandshülsen in verschiedenen Stärken genutzt werden.

Nachteilig wirkt sich dabei aus, dass lediglich eine Ausrichtung der Leiterkarten in zwei Dimensionen - und zwar in der Ebene der Leiterkarte selber - möglich ist. Durch abweichende Maße von beispielsweise auf den Leiterkarten angebrachten Schnittstellenbaugruppen kann auch ein Ausgleich der Leiterplatte senkrecht zu ihrer Ebene nötig sein. Nur so kann eine Übereinstimmung der auf der Leiterkarte vorhandenen Anschlusspunkte mit am Gehäuse angeformten Verrastungselementen gewährleistet werden.

Zudem sind für die im Stand der Technik bekannten Lösungen zusätzliche Halteelemente nötig. Diese können verloren gehen und stellen einen höheren Kostenaufwand für Herstellung und Montage dar.

### Aufgabenstellung

Der Erfindung liegt daher die Aufgabe zugrunde, ein Gehäuse zur Aufnahme von elektrischen Leiterkarten so auszubilden, dass ein Ausgleich von fertigungstechnischen oder modellabhängigen Maßen sowohl in der Leiterkartenebene als auch senkrecht zur Leiterkartenebene ermöglicht wird. Zudem soll ein Ausrichten der Leiterkarte im Gehäuse ohne zusätzliche Halteelemente ermöglicht werden.

Diese Aufgabe wird durch die Merkmale des kennzeichnenden Teils des unabhängigen Anspruchs 1 gelöst.

Vorteilhafte Ausgestaltungen der Erfindung sind in den Unteransprüchen angegeben.

Bei der Erfindung handelt es sich um ein Gehäuse, bestehend aus einer ersten Gehäusehälfte und einer zweiten Gehäusehälfte. Die beiden Gehäusehälften bilden zusammengesetzt das, einen Hohlraum umschließende Gehäuse. Der Hohlraum im Gehäuse ist zur Aufnahme einer elektrischen Leiterkarte vorgesehen.

Die Gehäusehälften werden bevorzugt aus Polymer-Formteilen hergestellt. Diese können im Spritzgussverfahren in beliebiger Form hergestellt werden und nehmen die Leiterkarte elektrisch nicht leitend auf.

Zur Aufnahme und Positionierung der elektrischen Leiterkarte, verfügen die beiden Gehäusehälften über eine Gruppe von Lagern, an welchen die Leiterkarte mit Lagerpunkten aufliegt. Dabei liegt eine erste Oberfläche der Lagerpunkte auf den Auflagern der ersten Gehäusehälfte auf. Eine zweite Oberfläche der Lagerpunkte liegt auf den Gegenauflagern der zweiten Gehäusehälfte auf.

Je nach Abstand der Auflager und Gegenauflager zueinander, sowie Stärke der Leiterkarte, wird diese mit Spiel leicht beweglich, oder mit Übermaß unter Druck, unbeweglich zwischen den Lagern gehalten.

Zur Lösung der erfindungsgemäßen Aufgabe, sind den Gehäusehälften zumindest eine zweite Gruppe Lager angeformt. Die zweiten Auflager und Gegenauflager liegen in einer Ebene, die senkrecht versetzt, parallel zur Ebene der ersten Gruppe von Lagern verläuft. Dadurch kann die Leiterkarte, je nachdem in welcher Gruppe von Lagern sie aufgenommen ist, in verschiedenen Ebenen angeordnet werden.

Die Anzahl der Lagergruppen kann dabei beliebig variiert werden. Je nach benötigter Auflösung der Abstufung, in welcher eine Leiterkarte in einem Gehäuse aufgenommen werden soll.

Auch die Anzahl von Lagerpaaren - Auflager in der ersten Gehäusehälfte und zugehörige Gegenauflager in der zweiten Gehäusehälfte - kann je nach Anwendung und Design von Leiterkarte und Gehäuse variiert werden. So verfügt in einer bevorzugten Ausbildungsform das Gehäuse über vier Auflager sowie vier zugeordnete Gegenauflager und die Leiterkarte über vier Lagerpunkte. Dabei liegen die Lagerpaare jeweils zwischen einem Auflager und einem Gegenauflager.

In einer weiteren Ausbildungsform ist nicht jedem Auflager genau ein Gegenauflager zugeordnet. So ist es ebenfalls denkbar, dass zwischen zwei Auflagern nur ein Gegenauflager angeordnet ist, oder anders herum. Das gesamte Gehäuse ist so mit vier Auflagern und nur zwei Gegenauflagern ausgestattet. Auch jede weitere Kombination an Lagern und Gegenlagern wäre denkbar, wird hier jedoch nicht weiter erläutert.

Weiterhin ist erfindungsgemäß vorgesehen, die Leiterkarte zur Aufnahme auf den verschiedenen Lagergruppen im Gehäuse mit verschiedenen Lagerpunktegruppen zu versehen. Die Leiterkarte verfügt dabei über so viele Lagerpunkte, wie das Gehäuse Auflager und Gegenauflager aufweist. Sofern das Gehäuse über Lagerpaare verfügt, ist diesen nur ein Lagerpunkt der Leiterkarte zugewiesen.

Je nachdem in welcher Ebene die Leiterkarte im Gehäuse aufgenommen werden soll, können die überflüssigen Lagerpunkte an der Leiterkarte entfernt werden. Hierfür sind an den Lagerpunkten Materialschwächungen, sogenannte Sollbruchstellen vorgesehen. Diese können durch eine Perforation oder eine Verjüngung im Material der Leiterkarte gebildet sein.

Auch ein Anritzen der Oberfläche an der gewünschten Bruchstelle zur Erzeugung von Spannungen zum Abbrechen ist denkbar.

Jeder Lagerpunktegruppe an der Leiterkarte ist eine bestimmt Lagergruppe - und damit auch Ebene - im Gehäuse zugewiesen. So definiert sich durch Entfernen der Lagerpunkte an der Leiterkarte die Ebene und Gruppe von Lagern im Gehäuse an der die verbleibenden Lagerpunkte aufliegen.

Des Weiteren verfügen die Leiterkarte und mindestens eine der Gehäusehälften über Bohrungen zum Einfügen eines Positionierungsstiftes. Mittels des Positionierungsstiftes wird die Lage der Leiterkarte im Gehäuse in der durch die Lagerpunkte und Lager definierten Ebene bestimmt.

Die Bohrungen in der mindestens einen Gehäusehälfte bilden Positionsaufnahmen. Die Positionsaufnahmen verlaufen vorzugsweise linear. Die Bohrungen in der Leiterkarte bilden Positionsbohrungen, welche vorzugsweise in selber Anzahl vorhanden sind, wie die Positionsaufnahmen in der mindestens einen Gehäusehälfte. Auch die Positionsbohrungen sind linear entsprechend den Positionsaufnahmen ausgerichtet und jeweils einer Positionsaufnahme zugeordnet.

Die Abstände der Positionsaufnahmen sind erfindungsgemäß ungleich den Abständen der Positionsbohrungen. Dadurch ändert sich, je nachdem in welche Positionsaufnahme und Positionsbohrung ein Positionierungsstift eingefügt wird, die Position der Leiterkarte im Gehäuse. So ist eine variable Ausrichtung der Leiterkarte, linear entlang der Bohrungen möglich.

Weitere Ausgestaltungen der Erfindung sind in den Ansprüchen 2 - 9 beschrieben.

### Ausführungsbeispiel

Ein Ausführungsbeispiel der Erfindung ist in der Zeichnung dargestellt und wird im Folgenden näher erläutert. Es zeigen:
- Fig. 1: eine erste Gehäusehälfte;
- Fig. 2: eine zweite Gehäusehälfte;
- Fig. 3: eine Leiterkarte;
- Fig. 4a - 4b: eine erste Gehäusehälfte mit eingesetzter Leiterkarte; und
- Fig. 5: ein geöffnetes Gehäuse mit eingesetzter Leiterkarte und angeschlossenem Steckverbinder.

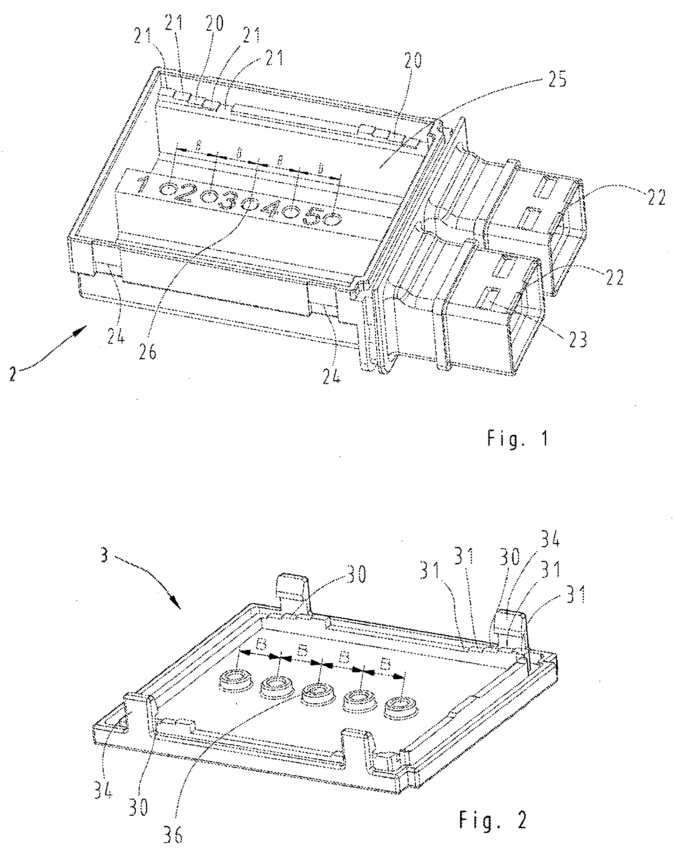

In der Fig.1 ist ein aus einer räumlichen Ansicht dargestellte erste Gehäusehälfte 2 gezeigt. Die einseitig offene Gehäusehälfte 2 bildet zusammen mit einer zweiten Gehäusehälfte 3 ein Gehäuse 1. An ihrer rechts dargestellten Seite verfügt die erste Gehäusehälfte 2 über zwei Kontaktierungsöffnungen 22. Diese sind zur Kontaktierung von in der Gehäusehälfte 2 aufzunehmenden - hier nicht dargestellten - elektrischen Bauteilen vorgesehen.

Die Kontaktierungsöffnungen 22 sind in diesem Ausführungsbeispiel grob flanschförmig ausgebildet und verfügen über Rastmittel 23. Die Rastmittel 23 dienen zur Verrastung eines Steckverbinders 9 mit dem Gehäuse 1.

Der von der ersten Gehäusehälfte 2 gebildete Hohlraum 25 dient zur Aufnahme einer elektrischen Leiterkarte 50. In den seitlichen Wänden der ersten Gehäusehälfte 2 sind gegenüberliegend jeweils zwei Auflager 20 vorgesehen - zwei sichtbar, zwei bedingt durch die Darstellung nicht sichtbar. Diese dienen zur Auflage einer Leiterkarte 50.

Erfindungsgemäß sind neben den Auflagern 20 noch weitere Auflager 21 in der ersten Gehäusehälfte 2 vorgesehen. Diese weiteren Auflager 21 sind stufenmäßig neben den Auflagern 20 angeformt. In diesem Ausführungsbeispiel jeweils zwei mit einem höheren Niveau - links von der Aufnahme 20 - und zwei mit einem niedrigeren Niveau - rechts von der Aufnahme 20.

Die Auflager 20, 21 sind jeweils an der sichtbaren Wandung der ersten Gehäusehälfte 2 eingeformt, wie auch in der nicht sichtbaren Wandung. Dadurch ergeben sich in jedem der fünf Niveau-Ebenen vier Auflager.

Mittig im Hohlraum 25 der ersten Gehäusehälfte 2 sind in einem länglichen Steg fünf Bohrungen vorgesehen. Diese Bohrungen bilden Positionsaufnahmen 26 und dienen zur Aufnahme eines Positionierungsstiftes 7. Die Ausrichtung der hier fünf Positionsaufnahmen 26 zueinander entspricht zweckmäßig der Steckrichtung eines anzuschließenden Steckverbinders 9.

Um das Gehäuse 1 auch von der offenen Seite der ersten Gehäusehälfte 2 zu verschließen ist eine zweite Gehäusehälfte 3 vorgesehen. Diese ist auf die erste Gehäusehälfte 2 aufsetzbar und bildet mit dieser zusammen das Gehäuse 1.

Eine solche zweite Gehäusehälfte 3 ist in der Fig. 2 gezeigt. Dem im Wesentlichen flach ausgebildete Bauteil sind hier vier Rastmittel 34 angeformt. Diese verrasten im zusammen gesetzten Zustand der beiden Gehäusehälften 2, 3 mit ebenfalls vier Rastmitteln 24 der ersten Gehäusehälfte 2. Die Rastmittel 24 sind dabei in den Wandungen der ersten Gehäusehälfte 2 eingebracht.

Auch ist eine andere oder zusätzliche Verbindung der beiden Gehäusehälften 2, 3 denkbar. So könnten diese in einer weiteren Ausführungsform beispielsweise miteinander verklebt sind. Auch eine einteilige Ausführung der Gehäusehälften 2, 3, verbunden mit einem Filmscharnier und nur einseitigen Rastmitteln ist denkbar.

Die beiden Gehäusehälften 2, 3 verfügen in der dargestellten Ausführungsform zusätzlich über eine Labyrinth-Dichtung im Übergangsbereich. Diese verhindert bei einem Vergießen des Gehäuses 1 ein Eindringen von Vergussmasse. Hierauf wird jedoch nicht weiter eingegangen, da dies nicht Bestandteil der Erfindung ist und aus dem Stand der Technik bereits mehrfach bekannt ist.

Auf der innenliegenden Seite der zweiten Gehäusehälfte 3 sind, wie auch der ersten Gehäusehälfte 2, Positionsaufnahmen 36 angeformt. Diese Positionsaufnahmen 36 sind achssymmetrisch den Positionsaufnahmen 26 der ersten Gehäusehälfte 2 angeordnet und ebenfalls zur Aufnahme des Positionierungsstiftes 7 vorgesehen.

Des Weiteren sind auf der innenliegenden Seite der zweiten Gehäusehälfte 3 in den Randbereichen gegenüberliegend jeweils zwei Gegenauflager 30 vorgesehen. Diese dienen zur Auflage der elektrischen Leiterkarte 50.

Erfindungsgemäß sind neben den Gegenauflagern 30 noch weitere Gegenauflager 31 an der zweiten Gehäusehälfte 3 vorgesehen. Diese weiteren Gegenauflager 31 sind stufenmäßig neben den Gegenauflagern 30 angeformt. In diesem Ausführungsbeispiel jeweils zwei mit einem höheren Niveau und zwei mit einem niedrigeren Niveau.

In diesem Ausführungsbeispiel ist jeweils ein Gegenauflager 30, 31 der zweiten Gehäusehälfte 3 einem Auflager 20, 21 der ersten Gehäusehälfte 2 zugeordnet. Die Auflager 20, 21 und Gegenauflager 30, 31 bilden Lagerpaare 20/30 sowie weitere Lagerpaare 21/31. Die Lagerpaare 20/30, 21/31 bilden bei zusammengesetzten Gehäusehälften 2, 3 einen Aufnahmespalt zur Aufnahme einer Leiterkarte 50 aus.

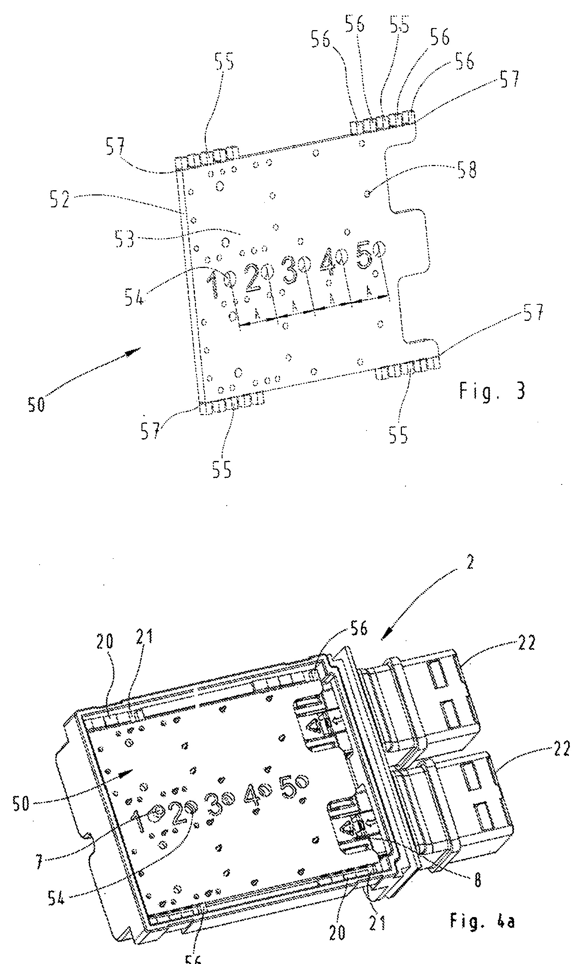

Die Fig. 3 zeigt eine Leiterkarte 50 zur Aufnahme in dem Gehäuse 1. Die im Groben der Form des Gehäuses 1 entsprechende Leiterkarte 50 verfügt zweckmäßig über eine Mehrzahl von Bauteilbohrungen 58. In diese Bohrungen können elektrische Bauteile, Stecker, Schnittstellen oder Bedienelemente eingesetzt und beispielsweise verlötet werden. Auf die Art dieser Bauteile wird nicht weiter eingegangen, da dies für die Erfindung nicht relevant ist.

In den Randbereichen der Leiterkarte 50 ist eine Mehrzahl von Lagerpunkten 55, 56 vorgesehen. Dabei entsprechen die Lagerpunkte 55 in ihrer Position den Lagerpaaren 20/30. Die zusätzlichen Lagerpunkte 56 entsprechen in ihrer Position den weiteren Lagerpaaren 21/31.

Im montierten Zustand lagert die Leiterkarte 50 mit ihren Lagerpunkten 55, 56 zwischen den Lagerpaaren 20/30, 21/31. Dabei berührt die Leiterplatte 50 mit einer ersten Oberfläche 52 die Auflager 20, 21 und mit einer zweiten Oberfläche 53 die Gegenauflager 30, 31. Je nach Auslegung des Aufnahmespalts zwischen Auflager 20, 21 und Gegenauflager 30, 31 sowie der Stärke 51 der Leiterkarte 50 ist diese leicht beweglich oder klemmend zwischen den Lagerpaaren 20/30, 21/31 gelagert.

Die Lagerpunkte 55, 56 der Leiterkarte 50 sind jeweils durch eine Materialschwächung 57 - einer so genannten Sollbruchstelle - an der Leiterkarte 50 angeformt. An diesen Sollbrauchstellen können einzelne Lagerpunkte 55, 56 abgebrochen und entfernt werden. Durch das Entfernen von in diesem Ausführungsbeispiel sechzehn Lagerpunkten 55, 56 ergibt sich aus den verbleibenden vier Lagerpunkten 55, 56 und dem Niveau der zugeordneten Lagerpaare 20/30, 21/31 das Niveau der Leiterkarte 50 im Gehäuse 1.

Um die Niveau-Anpassung der Leiterkarte 50 im Gehäuse 1 genauer darzustellen, sind in den Fig. 4a - 4c drei von fünf verschiedenen Möglichkeiten gezeigt und im Folgenden beschrieben.

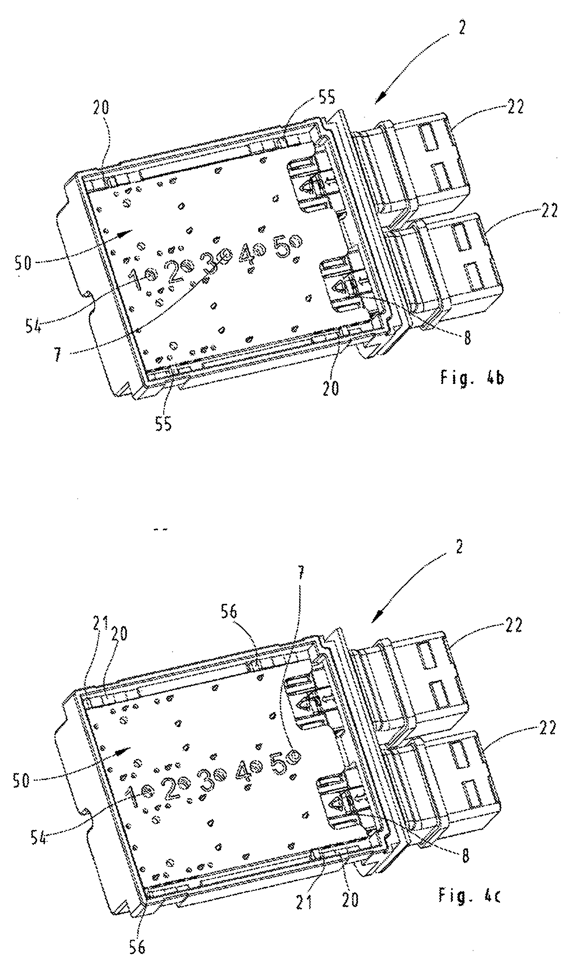

Alle Figuren 4 zeigen eine erste Gehäusehälfte 2 mit einer darin eingesetzten Leiterkarte 50. Auf der Leiterkarte 50 sind zwei Bauelemente 8 angebracht. Diese sind nicht genauer beschrieben. Lediglich sei gesagt, dass die Bauelemente 8 zur Kontaktierung mittels eines Steckverbinders 9 durch die Kontaktierungsöffnungen 22 vorgesehen sind.

In Fig. 4a sind von der Leiterkarte 50 die vier Lagerpunkte 55, sowie zwölf zusätzliche Lagerpunkte 56 entfernt worden, so dass nur noch vier, jeweils rechts dargestellte zusätzliche Lagerpunkte 56 vorhanden sind. Dadurch ergibt sich ein unterstes Niveau der Leiterkarte 50 auf den untersten, rechts liegenden Auflagern 21.

In Fig. 4b sind von der Leiterkarte 50 alle sechzehn zusätzlichen Lagerpunkte 56 entfernt worden, so dass nur noch die Lagerpunkte 55 vorhanden sind. Dadurch ergibt sich ein mittleres Niveau der Leiterkarte 50 auf den Auflagern 20.

In Fig. 4c sind von der Leiterkarte 50 die vier Lagerpunkte 55, sowie sechzehn zusätzliche Lagerpunkte 56 entfernt worden, so dass nur noch vier, jeweils links dargestellte zusätzliche Lagerpunkte 56 vorhanden sind. Dadurch ergibt sich ein höchstes Niveau der Leiterkarte 50 auf den höchsten, links liegenden Auflagern 21.

Neben der Niveau-Anpassung sind in den Fig. 4a - 4c noch drei, in Steckrichtung anzuschließender Steckverbinder verschieden ausgerichtete Positionen der Leiterkarte 50 dargestellt.

Zur Fixierung der Leiterkarte 50 im Gehäuse 1 wird eine Positionierungsstift 7 durch eine von hier fünf Positionsbohrungen 54 in der Leiterkarte 50 und in eine der Positionsaufnahmen 26 in der ersten Gehäusehälfte 2 gesteckt. Jeweils eine Positionsbohrung 54 ist einer der Positionsaufnahmen 26 zugeordnet.

Die Abstände A der Positionsbohrungen 54 sind größer, als die Abstände B der Positionsaufnahmen 26 zueinander. Dadurch ergibt sich, je nachdem in welche Positionsbohrung 54 und zugeordnete Positionsaufnahme 26 der Positionierungsstift 7 gesteckt wird, eine andere Ausrichtung der Leiterkarte 50 im Gehäuse 1.

In der dargestellten Figur 4a ist die in Richtung der Kontaktierungsöffnungen 22 vorderste Position gezeigt. In Figur 4b die mittlere und in Figur 4c die in Richtung der Kontaktierungsöffnungen 22 hinterste Position.

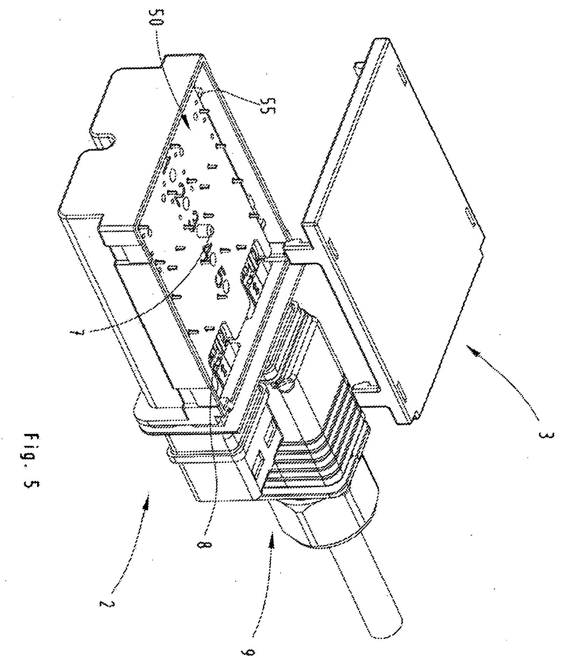

In der Fig. 5 ist abschließend noch eine gesamte Baugruppe mit einer ersten Gehäusehälfte 2, einer zweiten Gehäusehälfte 3, einer Leiterkarte 50 und einem angeschlossenen Steckverbinder 9 gezeigt.

Der Steckverbinder 9 ist mit einem von zwei auf der Leiterkarte 50 angebrachten Bauelementen 8 verbunden. Dabei verrastet der Steckverbinder 9 mit den Rastmitteln 23 an der einen Kontaktierungsöffnung 22 der ersten Gehäusehälfte 2.

Die zweite Gehäusehälfte 3 ist über der ersten Gehäusehälfte 2 dargestellt und muss nur noch auf diese gesetzt werden und mittels der Rastmittel 24, 34 verrasten.

### Bezugszeichenliste

- 1: Gehäuse
- 2: erste Gehäusehälfte
- 20: Auflager
- 21: weitere Auflager
- 22: Kontaktierungsöffnung
- 23: Rastmittel
- 24: Rastmittel
- 25: Hohlraum
- 26: Positionsaufnahme
- 3: zweite Gehäusehälfte
- 30: Gegenauflager
- 31: weitere Gegenauflager
- 34: Rastmittel
- 36: Positionsaufnahme
- 20/30: Lagerpaar
- 21/31: weitere Lagerpaare
- 50: Leiterkarte
- 52: erste Oberfläche
- 53: zweite Oberfläche
- 51: Stärke der Leiterkarte
- 54: Positionsbohrung
- 55: Lagerpunkte
- 56: zusätzliche Lagerpunkte
- 57: Materialschwächung
- 58: Bauteilbohrungen
- 7: Positionierungsstift
- 8: Bauelement
- 9: Steckverbinder

- A: Abstand der Positionsbohrungen 54
- B: Abstand der Positionsaufnahmen 26, 36

## Patentansprüche

1. Gehäuse (1), sowie elektrische Leiterkarte (50) zur Aufnahme in einem Gehäuse (1),
• wobei das Gehäuse (1) aus einer erste Gehäusehälfte (2) und einer zweite Gehäusehälfte (3) gebildet wird,
• wobei die erste Gehäusehälfte (2) zumindest zwei Auflager (20) und die zweite Gehäusehälfte (3) zumindest zwei Gegenauflager (30) aufweist, welche zusammen eine Gruppe von Lagern bilden,
• wobei die Auflager (20) mit den Gegenauflagern (30) einen Aufnahmespalt in etwa der Stärke (51) der elektrischen Leiterkarte (50) bilden,
• wobei die elektrische Leiterkarte (50) mit einer ersten Oberfläche (52) auf den Auflagern (20) aufliegt und mit einer zweiten Oberfläche (53) auf den Gegenauflagern (30) aufliegt,
• wobei die Leiterkarte (50) Lagerpunkte (55) aufweist, an welchen die Leiterkarte (50) auf den Auflager (20) und den Gegenauflagern (30) des Gehäuses (1) aufliegt,
• wobei im Gehäuse (1) mindestens eine weitere Gruppe von Lagern, bestehend aus weiteren Auflager (21) und weiteren Gegenauflager (31), vorgesehen ist, und
• wobei ein von den Auflagern (21) und Gegenauflagern (31) gebildeter Aufnahmespalt (41) in einer parallel zum Aufnahmespalt versetzten Ebene liegt,
**dadurch gekennzeichnet,**
**dass** die Leiterkarte (50) mindestens zwei Positionsbohrungen (54) aufweist, wobei die Positionsbohrungen (54) linear in einem Abstand (A) zueinander angeordnete sind,
**dass** zumindest eine der Gehäusehälften (2, 3) mindestens zwei Bohrungen aufweist, wobei die Bohrungen Positionsaufnahmen (26, 36) bilden und linear in einem Abstand (B) zueinander angeordnete sind, und
**dass** jeweils eine Positionsaufnahme (26, 36) jeweils einer Positionsbohrung (54) der Leiterkarte (50) zugeordnet ist und zu dieser achsparallel ausgerichtet ist.

2. Gehäuse (1) und elektrische Leiterkarte (50) nach Anspruch 1, **dadurch gekennzeichnet,**
**dass** ein Positionierungsstift (7) in eine der Positionsbohrungen (54) und die zugeordnete Positionsaufnahme (26, 36) einsteckbar ist.

3. Gehäuse (1) und elektrische Leiterkarte (50) nach Anspruch 1 oder 2, **dadurch gekennzeichnet,**
**dass** der Abstand (A) ungleich dem Abstand (B) ist.

4. Gehäuse (1) und elektrische Leiterkarte (50) nach einem der vorstehenden Ansprüche, **dadurch gekennzeichnet,**
**dass** die Auflager (20, 21) und die Gegenauflager (30, 31) jeweils stufenförmig nebeneinander in den Gehäusehälften (2, 3) angeformt sind.

5. Gehäuse (1) und elektrische Leiterkarte (50) nach einem der vorstehenden Ansprüche, **dadurch gekennzeichnet,**
**dass** jeweils ein Auflager (20, 21) und ein Gegenauflager (30, 31) zueinander angeordnet ein Lagerpaar (20/30, 21/31) bilden,
wobei die Leiterkarte (50) zwischen den Lagerpaaren (20/30, 21/31) angeordnet ist.

6. Gehäuse (1) und elektrische Leiterkarte (50) nach einem der vorstehenden Ansprüche, **dadurch gekennzeichnet,**
**dass** der Aufnahmespalt kleiner oder gleich der Stärke der Leiterkarte (50) ist.

7. Gehäuse (1) und elektrische Leiterkarte (50) nach einem der vorstehenden Ansprüche, **dadurch gekennzeichnet,**
**dass** die Leiterkarte (50) zusätzliche Lagerpunkte (56) aufweist, wobei die Lagerpunkte (55) den Positionen der Auflager (20) und der Gegenauflager (30) entsprechen und die zusätzlichen Lagerpunkte (56) den Positionen der weiteren Auflager (21) sowie der weiteren Gegenauflager (31) entsprechen,
wobei die Lagerpunkte (55, 56) durch eine vorgesehene Materialschwächung (57) von der Leiterkarte (50) abtrennbar sind.

## Claims

1. Housing (1) and electrical circuit board (50) which is to be accommodated in a housing (1),
• wherein the housing (1) is formed from a first housing half (2) and a second housing half (3),
• wherein the first housing half (2) has at least two supports (20), and the second housing half (3) has at least two mating supports (30), which supports and mating supports together form a group of bearings,
• wherein the supports (20) together with the mating supports (30) form an accommodation gap of approximately the thickness (51) of the electrical circuit board (50),
• wherein the electrical circuit board (50) rests on the supports (20) by way of a first surface (52) and rests on the mating supports (30) by way of a second surface (53),
• wherein the circuit board (50) has bearing points (55) at which the circuit board (50) rests on the supports (20) and the mating supports (30) of the housing (1),
• wherein at least one further group of bearings, comprising further supports (21) and further mating supports (31), is provided in the housing (1), and
• wherein an accommodation gap (41), which is formed by the supports (21) and the mating supports (31), lies in a plane which is offset parallel to the accommodation gap,
**characterized**
**in that** the circuit board (50) has at least two positioning bores (54), wherein the positioning bores (54) are arranged in a linear manner at a distance (A) from one another,
**in that** at least one of the housing halves (2, 3) has at least two bores, wherein the bores form positioning receptacles (26, 36) and are arranged in a linear manner at a distance (B) from one another, and
**in that** in each case one positioning receptacle (26, 36) is associated with in, each case one positioning bore (54) in the circuit board (50) and is oriented in an axially parallel manner in relation to the said positioning bore.

2. Housing (1) and electrical circuit board (50) according to Claim 1,
**characterized**
**in that** a positioning pin (7) can be inserted into one of the positioning bores (54) and the associated positioning receptacle (26, 36).

3. Housing (1) and electrical circuit board (50) according to Claim 1 or 2,
**characterized**
**in that** the distance (A) is not equal to the distance (B).

4. Housing (1) and electrical circuit board (50) according to one of the preceding claims,
**characterized**
**in that** the supports (20, 21) and the mating supports (30, 31) are each integrally formed in steps next to one another in the housing halves (2, 3).

5. Housing (1) and electrical circuit board (50) according to one of the preceding claims,
**characterized**
**in that** in each case one support (20, 21) and one mating support (30, 31), arranged relative to one another, form a bearing pair (20/30, 21/31),
wherein the circuit board (50) is arranged between the bearing pairs (20/30, 21/31).

6. Housing (1) and electrical circuit board (50) according to one of the preceding claims,
**characterized**
**in that** the accommodation gap is less than or equal to the thickness of the circuit board (50).

7. Housing (1) and electrical circuit board (50) according to one of the preceding claims,
**characterized**
**in that** the circuit board (50) has additional bearing points (56),
wherein the bearing points (55) correspond to the positions of the supports (20) and of the mating supports (30), and the additional bearing points (56) correspond to the positions of the further supports (21) and of the further mating supports (31),
wherein the bearing points (55, 56) can be detached from the circuit board (50) by an included material weak point (57).

## Revendications

1. Boîtier (1) et carte de circuit imprimé électrique (50) destinée à être logée dans un boîtier (1),
- dans lequel le boîtier (1) est constitué d'une première moitié de boîtier (2) et d'une seconde moitié de boîtier (3),
- dans lequel la première moitié de boîtier (2) comprend au moins deux supports (20) et les deux moitiés de boîtier (3) comprennent au moins deux supports antagonistes (30) qui forment ensemble un groupe de supports,
- dans lequel les supports (20) forment avec les supports antagonistes (30) une fente de réception ayant sensiblement l'épaisseur (51) de la carte de circuit imprimé électrique (50),
- dans lequel la carte de circuit imprimé électrique (50) est disposée de manière à ce qu'une première surface (52) soit placée sur les supports (20) et à ce qu'une seconde surface (53) soit placée sur les supports antagonistes (30),
- dans lequel la carte de circuit imprimé (50) comprend des points d'appui (55) à l'emplacement desquels la carte de circuit imprimé (50) repose sur les supports (20) et les supports antagonistes (30) du boîtier (1),
- dans lequel au moins un autre groupe de supports, constitué d'autres supports (21) et d'autres supports antagonistes (31), est prévu dans le boîtier (1), et
- dans lequel une fente de réception (41) formée par les supports (21) et les supports antagonistes (31) est située dans un plan décalé parallèlement à la fente de réception,
**caractérisé en ce que** la carte de circuit imprimé (50) comprend au moins deux alésages de positionnement (54), dans lequel les alésages de positionnement (54) sont disposés linéairement selon un espacement (A) l'un par rapport à l'autre,
**en ce qu'**au moins l'une des moitiés de boîtier (2, 3) comprend au moins deux alésages, dans lequel les alésages forment des réceptacles de positionnement (26, 36) et sont disposés de manière linéaire selon un espacement (B) l'une par rapport à l'autre, et **en ce qu'**un réceptacle de positionnement respectif (26, 36) est respectivement associé à un alésage de positionnement (54) de la carte de circuit imprimé (50) et est orienté parallèlement à l'axe de cette dernière.

2. Boîtier (1) et carte de circuit imprimé électrique (50) selon la revendication 1,
**caractérisé en ce qu'**une tige de positionnement (7) peut être insérée dans l'un des alésages de positionnement (54) et dans les réceptacles de positionnement associés (26, 36).

3. Boîtier (1) et carte de circuit imprimé électrique (50) selon la revendication 1 ou 2, **caractérisé en ce que** l'espacement (A) est différent de l'espacement (B).

4. Boîtier (1) et carte de circuit imprimé électrique (50) selon l'une quelconque des revendications précédentes,
**caractérisé en ce que** les supports (20, 21) et les supports antagonistes (30, 31) sont respectivement façonnés sous la forme de gradins placés côte à côte dans les moitiés de boîtier (2, 3).

5. Boîtier (1) et carte de circuit imprimé électrique (50) selon l'une quelconque des revendications précédentes,
**caractérisé en ce qu'**un support (20, 21) et un support antagoniste (30, 31) forment respectivement une paire de supports (20/30, 21/31) agencés l'un par rapport à l'autre, dans lequel la carte de circuit imprimé (50) est disposée entre les paires de supports (20/30, 21/31).

6. Boîtier (1) e.t carte de circuit imprimé électrique (50) selon l'une quelconque des revendications précédentes,
**caractérisé en ce que** la fente de réception a une largeur inférieure ou égale à l'épaisseur de la carte de circuit imprimé (50).

7. Boîtier (1) et carte de circuit imprimé électrique (50) selon l'une quelconque des revendications précédentes,
**caractérisé en ce que** la carte de circuit imprimé (50) comprend en outre des points d'appui (56), dans lequel les points d'appui (55) correspondent aux positions des supports (20) et des supports antagonistes (30) et **en ce que** les points d'appui supplémentaires (56) correspondent aux positions des autres supports (21) et des autres supports antagonistes (31),
dans lequel les points d'appui (55, 56) peuvent être séparés de la carte de circuit imprimé (50) par un amincissement de matériau (57) prédéterminé.
